(19) Europäisches Patentamt

European Patent Office

Office européen des brevets

(11) **EP 0 819 984 B1**

(12) **EUROPÄISCHE PATENTSCHRIFT**

(45) Veröffentlichungstag und Bekanntmachung des Hinweises auf die Patenterteilung:
**08.05.2002   Patentblatt 2002/19**

(51) Int Cl.$^7$: **G03F 7/033**

(21) Anmeldenummer: **97111787.4**

(22) Anmeldetag: **11.07.1997**

(54) **Strahlungsempfindliches Aufzeichnungsmaterial für Flexodruckplatten**

Irradiation-sensitive recording material for flexographic printing plates

Matériel d'enregistrement sensible aux radiations pour des clichés flexographiques

(84) Benannte Vertragsstaaten:
**DE FR GB**

(30) Priorität: **16.07.1996   DE 19628541**

(43) Veröffentlichungstag der Anmeldung:
**21.01.1998   Patentblatt 1998/04**

(73) Patentinhaber:
• **DU PONT DE NEMOURS (DEUTSCHLAND) GMBH**
  **61343 Bad Homburg v.d.H. (DE)**
  Benannte Vertragsstaaten:
  **DE**
• **E.I. DU PONT DE NEMOURS AND COMPANY**
  **Wilmington Delaware 19898 (US)**
  Benannte Vertragsstaaten:
  **FR GB**

(72) Erfinder:
• **Fröhlich, Helmut H., Dr.**
  **63150 Heusenstamm (DE)**
• **Schröder, Hans Leander**
  **64354 Reinheim (DE)**

(56) Entgegenhaltungen:
**EP-A- 0 696 761**        **WO-A-95/08136**
**US-A- 4 994 344**        **US-A- 5 486 574**

**Beschreibung**

Die Erfindung betrifft ein strahlungsempfindliches Aufzeichnungsmaterial, das zur Herstellung von Druckformen für den Flexodruck geeignet ist. Die damit hergestellten Druckformen weisen verbesserte chemische und physikalische Eigenschaften, insbesonder eine verbesserte Resistenz gegenüber Ozon und eine niedrige Quellbarkeit in Ester und/oder Ketone enthaltenden Druckfarben auf.

Strahlungsempfindliche Aufzeichnungsmaterialien zur Herstellung von Druckformen sind beispielsweise aus EP-A 03 22 585 und US 4,323,636 bekannt. Solche Aufzeichnungsmaterialien enthalten zwischen einem Schichtträger und einer Deckfolie, die beispielsweise beide aus Kunststoffolien bestehten können, eine Schicht aus einer strahlungsempfindlichen Zusammensetzung. Wesentliche Bestandteile dieser strahlungsempfindlichen Zusammensetzung sind üblicherweise: a) mindestens ein polymeres Bindemittel, b) mindestens eine additionspolymerisierbare, ethylenisch ungesättigte Verbindung, c) mindestens ein Photoinitiator und/oder Photoinitiatorsystem, das unter Einstrahlung von aktinischem Licht in der Lage ist, eine Additionspolymerisation zu starten. Desweiteren können niedermolekulare Polymere und andere Hilfsstoffe in der strahlungsempfindlichen Zusammensetzung enthalten sein.

Thermoplastische elastomere Blockcopolymere als polymere Bindemittel sowie additionspolymerisierbare, ethylenisch ungesättigte Verbindungen und Photoinitiatoren und/oder Photoinitiatorsysteme in strahlungsempfindlichen Zusammensetzungen sind beispielsweise in US 4,323,636 beschrieben. Dort findet ein Polystyrol-Polyisopren-Polystyrol Blockcopolymer, ein hydriertes und auch ein nicht-hydriertes Polystyrol-Polybutadien-Polystyrol Blockcopolymer als polymeres Bindemittel Verwendung. Radiale Blockcopolymere in strahlungsempfindlichen Zusammensetzungen sind beispielsweise in WO 95/08136 beschrieben.

Die mit den derzeit im Handel erhältlichen strahlungsempfindlichen Aufzeichnungsmaterialien hergestellten Druckformen für den Flexodruck sind jedoch nur beschränkt in Kombination mit Druckfarben verwendbar, die Lösungsmittel und/oder Zusätze wie beispielsweise Ethylacetat, n-Propylacetat, Aceton, Methylisobutylketon, 2-Butanon (Methylethylketon) und/oder Isopropylacetat enthalten. Beispiel für solche Druckfarben sind sogenannte Zwei-Komponenten-Farben, die als Lösungsmittel im wesentlichen Ester wie Ethylacetat, n-Propylacetat und Isopropylacetat sowie Ketone wie Aceton und Ethylmethylketon enthalten. Solche Druckfarben finden beispielsweise beim Bedrucken von Bedruckstoffen wie Kunststoffolien aus LDPE, HDPE, coextrudiertes Polyethylen oder Polyester, NC-lackierte Aluminiumfolien, Papiere und Zellglas XS Verwendung. Diese Bedruckstoffe finden bei der Herstellung von Verpackungen mit höheren Beständigkeitsanforderungen, insbesondere für Lebensmittelverpak-

kungen Verwendung.

Durch eine starke Quellung von aus handelsüblichen, thermoplastische elastomere polymeren Bindemittel enthaltende strahlungsempfindlichen Aufzeichnungsmaterialien hergestellten Druckplatten während des Druckens mit solchen Druckfarben verschlechtert sich die Qualität des Druckergebnisses während des Druckverlaufes. Daher wird häufig von Druckfarbenherstellern die Verwendung von solchen Druckfarben nur in Verbindung mit Gummiklischees empfohlen. Die Herstellung solcher Gummiklischees ist jedoch sehr aufwendig. Ein weiterer Nachteil besteht in der beschränkten Resistenz der herkömmlichen Druckformen gegen Ozon, das beispielsweise bei einer Behandlung des Bedruckstoffes mittels Corona-Entladung zur besseren Benetzbarkeit des Bedruckstoffes mit der Druckfarbe entsteht. Dadurch ist die Haltbarkeit der herkömmlichen Druckformen während des Druckens sowie der Lagerung eingeschränkt. Alternativ wurde in EP 0 326 977 A2 Ethylen-Propylen-Alkadien-Terpolymerisate als Bindemittel für solche Druckplatten vorgeschlagen. Strahlungsempfindliche Zusammensetzungen, die solche Bindemittel enthalten, lassen sich jedoch schwer zu Druckformen verarbeiten. Die so hergestellten Druckformen besitzten jedoch nur eine begrenzte Auflösung und sind zudem nicht sehr auflagenstabil, so daß bei großen Druckauflagen die Druckform während des Druckens unbrauchbar wird und ersetzt werden muß.

Aufgabe der vorliegenden Erfindung ist die Bereitstellung einer Druckform für den Flexodruck, welche sich durch hohe Ozonbeständigkeit und eine niedrige Quellung in Ester enthaltenden Druckfarben auszeichnet.

Die Aufgabe wird gelöst durch ein strahlungsempfindliches Aufzeichnungsmaterial nach Anspruch 1 und die Verwendung des strahlungsempfindlichen Aufzeichnungsmaterials zur Herstellung von Druckformen für den Flexodruck gemäß Anspruch 12.

Geeignete polymere thermoplastische, elastomere Bindemittel sind radiale Blockcopolymer der Formel (I)

$$(I) \qquad ((A)n\text{-}(HD))_X\text{-}Y\text{-}((UD)\text{-}(A)m)_Z$$

ist, wobei A ein Polyvinylarylblock mit einem gewichtsgemitteltem Molekulargewicht von 4000 bis 20000 ist, m und n jeweils 0 oder 1 ist und im Molekül mindestens zwei Polyvinylarylblöcke A vorliegen müssen, HD ein hydrogenierter Polymerblock eines konjungierten Dienes mit einem gewichtsgemitteltem Molekulargewicht von 10000 bis 100000, Y eine mehrfunktionale Verbindung, UD ein nicht hydrierter Polymerblock eines konjungierten Dienes mit einem gewichtsgemitteltem Molekulargewicht von 1000 bis 80000, x eine ganze Zahl von 1 bis 20, bevorzugt 2 bis 4, z eine ganze Zahl von 1 bis 10, bevorzugt 1 und 4, ist, die Summe von x und z 3 bis 30, bevorzugt 3 bis 6, beträgt und der gewichtsmäßige Anteil der Summe der Polyvinylarylblöcke von 4 bis 35% beträgt.

Davon bevorzugte polymere thermoplastische, elastomere Bindemittel sind dabei solche der allgemeinen Formel (II).

$$(II) \qquad A\text{-}(HD))_X\text{-}Y\text{-}(UD)_Z$$

Bevorzugt werden solche Blockcopolymere der Formel (I) verwendet, bei denen x gleich 2, 3 oder 4, z gleich 1, 2, 3 oder 4 und die Summe von x und z gleich 3, 4, 5 oder 6 ist. Besonders bevorzugt sind dabei diejenigen, bei denen in der Formel (I) x und z jeweils 2 ist.

Die Vinylarylblöcke A der Formel (I) können beispielsweise Styrol, Alphamethylstyrol, andere alkylsubstituierte Styrole, alkoxysubstituierte Styrole, Vinylnaphtalene in polymerisierter Form enthalten. Bevorzugt bestehen die Vinylarylblöcke A in Formel (I) im wesentlichen aus Polystyrol.

Bevorzugt besteht HD im wesentlichen aus hydriertem Polybutadien.

Geeignete Diene zur Bildung von UD in Formel (I) sind beispielsweise 2-Methyl-1,3-pentadien, Isopren, Phenylbutadien, 3,4-Dimethylhexa-1,3-dien -1,3-dien und 4,5-Diethylocta-1,3-dien. Bevorzugt werden Diene verwendet, welche nicht mehr als 8 Kohlenstoffatome enthalten.

In einer besonders evorzugten Ausführung besteht UD im wesentlichen aus Polyisopren. Bevorzugt werden zur Herstellung des HD Blockes andere konjugierte Diene verwendet als zur Herstellung vom UD Block.

Generell kann jedes nach dem Stand der Technik bekannte Kupplungsreagenz zur Einführung der mehrfunktionalen Verbindung Y verwendet werden, welches sich an wenigstens drei Stellen mit den anionischen Enden der entsprechenden Polymerketten umsetzen kann. Beispiele hierfür sind SiX4, RSiX3, HSiX3, X3Si-SiX3, R-C(SiX3)3 und C(CH2SiX3)4 wobei X Fluor, Chlor, Brom, Jod, Alkoxyradikale, Carboxylatradikale und/oder Wasserstoffradikale sind und R für lineare oder verzweigte Kohlenwasserstoffradikale mit 1 bis 10 Kohlenstoffatomen, bevorzugt mit 1 bis 6 Kohlenstoffatomen besteht.

Solche Blockcopolymere sowie deren Herstellung und Methoden zur Bestimmung von deren gewichtsgemittelten Molekulargewichten sind beispielsweise in US 5,393,841und der darin zitierten Literatur für die Verwendung in Klebstoffen und Dichtungsmitteln beschrieben.

Das polymere Bindemittel wird in der strahlungsempfindlichen Zusammensetzung mit einem Gewichtsanteil von 20 bis 95 Gew.% eingesetzt wobei der Bereich von 30 bis 90 Gew.% bevorzugt ist. Besonders bevorzugt ist der Bereich von 40 bis 80 Gew.%

Geeignete additionspolymerisierbare, ethylenisch ungesättigte Verbindungen in der strahlungsempfindlichen Zusammensetzung haben im allgemeinen einen Siedepunkt von über 100°C bei Atmosphärendruck und ein Molekulargewicht von bis zu 3000, insbesondere von bis zu 2000. Im allgemeinen handelt es sich bei den additionspolymerisierbaren, ethylenisch ungesättigten Verbindungen um Ester der Acrylsäure und der Methacrylsäure, um Styrol und dessen Derivate, um Ester der Fumarsäure und der Maleinsäure, um Acryl- und Methacrylamide und um Allylverbindungen. Diese additionspolymerisierbaren, ethylenisch ungesättigten Verbindungen können eine oder mehr als eine additionspolymerisierbare, ethylenisch ungesättigte Doppelbindungen enthalten. Bevorzugt werden solche additionspolymerisierbaren, ethylenisch ungesättigten Verbindungen verwendet, die in einer strahlungsempfindlichen Zusammensetzung mit dem polymeren Bindemittel verträglich sind. Der Begriff "verträglich" zeigt an, daß die betreffende Komponente in der strahlungsempfindlichen Zusammensetzung moleculardispers verteilt werden kann oder den gleichen Brechungsindex hat, hierin keine Trübung hervorruft und sich auch im Laufe der Zeit nicht entmischt. Es kann sowohl eine additionspolymerisierbare, endständig ethylenisch ungesättigte Verbindung für sich alleine oder auch eine Kombination von zwei oder mehr dieser additionspolymerisierbaren, endständig ethylenisch ungesättigten Verbindungen in den strahlungsempfindlichen Zusammensetzung Verwendung finden.

Bevorzugt werden Ester der Acryl- und Methacrylsäure verwendet.

Der Gewichtsanteil der Summe dieser additionspolymerisierbaren, ethylenisch ungesättigten Verbindungen in der strahlungsempfindlichen Zusammensetzung liegt im Bereich von 0,5 bis 50, vorteilhafterweise 0,5 bis 30, vorzugsweise 1 bis 25 und insbesondere 2 bis 20 Gew.%.

Geeignete additionspolymerisierbare, endständig ethylenisch ungesättigte Verbindungen sind beispielsweise Allylmethacrylat, Benzylacrylat, Benzylmethacrylat, Bisphenol-A-diacrylat, Bisphenol-A-dimethacrylat, 1,4-Butandioldiacrylat, 1,3-Butandiolmethacrylat, 1,4-Butandioldimethacrylat, t-Butylacrylat, t-Butylaminoethylmethacrylat, Cyclohexylmethacrylat, Decamethyleneglycoldiacrylat, Diallylphthalat, Diethylenglycoldiacrylat, Dihydroxydicyclopentadienylacrylat, Dihydroxydicyclopentadienylmethacrylat, Dihydroxylimonendimethacrylat, N,N-Dimethylaminoethylacrylat, N,N-Dimethylaminoethylmethacrylat, 2,2-Dimethylolpropandiacrylat, Dimethylolpropantetraacrylat, Dipentaerythritolmonohydroxipentaacrylat, Dipropylenglycoldiacrylat, Divinylbenzol, Dodecandioldiacrylat, Dodecandioldimethacrylat, Ethylenglycoldiacrylat, Ethylenglycoldimethacrylat, Fumarsäuredi-n-butylester, Fumarsäuredi-n-octylester, Glycerylpropoxytriacrylat, Hexan-1,6-dioldiacrylat, Hexan-1,6-dioldimethacrylat, Hex-1-en-6-ylacrylat, Hydroxyethylacrylat, Hydroxyethylmethacrylat, Isodecylacrylat, Isobornylacrylat, Isobornylmethacrylat, Isooctylacrylat, Itaconsäurebisallylester, Laurylacrylat, Neopentylglycoldiacrylat, Neopentylglycoldimethacrylat, 2-Phenoxyethylacrylat, Stearylmethacrylat, Triallylcyanurat, Tridecylacrylat, Trimethylolpropantriacrylat, Trimethylolpropantrimethacrylat oder Tripropylenediacrylat.

In einer bevorzugten Ausführung enthält die strahlungsempfindliche Zusammensetzung eine Kombination von mindestens einem mono- oder bifunktionalem Acrylat oder Methacrylat und mindestens einem oligofunktionalen Acrylat oder Methacrylat.

Oligofunktionale Acrylate oder Methacrylate sind solche Verbindungen, die mehr als zwei Acrylat- oder Methacrylatreste enthalten.

Besonders bevorzugt ist dabei eine Kombination von Isobornylacrylat und Dipentaerythritolpentaacrylat. Ganz besonders bevorzugt ist in der strahlungsempfindlichen Zusammensetzung eine Kombination von Isobornylacrylat, einem oligofunktionalen Acrylat oder Methacrylat und einem weiteren monofunktionalem Acrylat oder Methacrylat, dessen Homopolymer einen Glasübergangspunkt von weniger als - 40° C aufweist,.

Monofunktionelle Acrylate oder Methacrylat, deren Homopolymere einen Glasübergangspunkt unter - 40° C aufweisen, sind beispielsweise Methoxyacrylat, Isooctylacrylat, Methacrylester 13C, Ethyltriglycolmethacrylat, Tridecylacrylat und Laurylacrylat. Eine oder auch mehrere dieser Acrylate und Methacrylat sind in der strahlungsempfindlichen Zusammensetzung bevorzugt in einer Menge von 0,5 bis 12 Gewichtprozent enthalten Photoinitiatoren und/oder Photoinitiatorsysteme, die unter Einstrahlung von aktinischem Licht in der Lage ist, eine Additionspolymerisation zu starten, werden in der strahlungsempfindlichen Zusammensetzung zu 0,001 bis 10 Gewichtsprozent, vorzugsweise 0,1 bis 7, vorteilhafterweise 0,2 bis 5 und insbesondere 0,3 bis 4 Gew.% verwendet Die geeignete Menge wird von den weiteren Bestandteilen der Zusammensetzung mitbestimmt und kann durch den Fachmann in Versuchsreihen ermittelt werden.

Beispiele für solche Photoinitiatoren und/oder Photoinitiatorsysteme sind Benzoin oder Benzoinderivate wie dessen Methyl-, Isopropyl-, n-Butyl- oder Isobutylether, symmetrisch oder unsymmetrisch substituierte Benzilacetale wie Benzildimethylacetal, Benzil-1-methyl-1-ethylacetal, oder Acylarylphosphinoxide wie 2-Dimethoxibenzoyldiphenylphosphinoxid, 2,4,6-Trimethylbenzoyldiphenylphosphinoxid, 2,4,6-Trimethylbenzoylphenylphosphinsäureethylester, oder 2,4,6-Trimethylbenzoylphenylphosphinsäure-Natrium-Salz oder substituierte oder unsubstituierte Chinone wie Ethylanthrachinon, Benzanthrachinon, Benzophenon oder 4,4'-Bis-(dimethylamino)benzophenon. Sie können alleine oder im Gemisch miteinander und/oder in Verbindung mit Coinitiatoren verwendet werden, beispielsweise Ethylanthrachinon mit 4,4'-Bis-(dimethylamino)benzophenon, Benzoinmethylether mit Triphenylphosphin, Diacylphosphinoxide mit tertiären Aminen und Acylarylphosphinoxide mit Benzildimethylacetal.

Die strahlungsempfindliche Zusammensetzung kann einen oder mehrere Hilfsstoffe enthalten, mit deren Hilfe das anwendungstechnische Eigenschaftsprofil des erfindungsgemäßen strahlungsempfindlichen Aufzeichnungsmaterials sowie der daraus hergestellten Druckplatten beziehungsweise Druckformen für den Flexodruck variiert werden kann.

Hierbei handelt es sich vor allem um Weichmacher, Inhibitoren der thermischen Polymerisation, Farbmittel, photochrome Zusätze, Mittel zur Verbesserung der Reliefstruktur, Vernetzungshilfsmittel, Antioxidantien, Antiozonantien, Füllstoffe, Flußmittel oder Formtrennmittel. Ihre Menge sollte 40 Gew.% der strahlungsempfindlichen Zusammensetzung nicht überschreiten.

Weichmacher dienen beispielsweise zur Steuerung von bestimmten Eigenschaften des strahlungsempfindlichen Aufzeichnungsmaterials wie Strahlungsempfindlichkeit und Verarbeitbarkeit und Eigenschaften der nach der Verarbeitung entstehenden Druckformen wie Härte und Flexibilität. Gut geeignet sind solche Weichmacher, die mit dem polymeren Bindemittel verträglich sind. Beispiele für Weichmacher sind synthetische Oligomere oder Harze, wie Oligostyrol, oligomere Styrol-Butadien-Copolymerisate, Polyisobutylen, Polybuten-1, 1,2- oder 1,4-Oligobutadiene, Oligopantediene und Oligobuten-1, Ethylen-Propylen-Dien-Kautschuke mit einem mittleren gewichtsgemittelten Molekulargewicht zwischen 300 und 25000. So ist die Verwendung von Polyisobuten als Weichmacher in einer strahlungsempfindlichen Zusammensetzung beispielsweise in WO 93/15441 beschrieben. Diese Weichmacher können für sich alleine oder in Kombination mit einem oder mehreren anderen Weichmachern in der strahlungsempfindlichen Zusammensetzung verwendet werden.

In einer bevorzugten Ausführung wird ein Ethylen-Propylen-Dien-Kautschuk mit einem mittleren Molekulargewicht zwischen 500 und 25000 verwendet. In einer weiteren bevorzugten Ausführung wird die Kombination von Polybuten-1 mit einem mittleren Molekulargewicht zwischen 300 und 10000 mit einem Polybutadien-1,2 mit einem mittleren gewichtsgemitteltem Molekulargewicht zwischen 300 und 10000 in einem Verhältnis von 5:1 bis 1:5 verwendet. Bevorzugt wird eine Menge an Weichmacher beziehungsweise Weichmachern von 5 bis 30 Gewichtsprozent, bezogen auf die strahlungsempfindliche Zusammensetzung, verwendet.

Inhibitoren der thermischen Polymerisation werden im allgemeinen in einer Menge von 0,001 bis 3 Gew.% der strahlungsempfindlichen Zusammensetzung zugesetzt. Sie weisen im allgemeinen keine nennenswerte Eigenabsorption von Licht in dem aktinischen Bereich auf, in dem der Photoinitiator und/oder das Photoinitiatorsystem absorbiert. Beispiele für solche Inhibitoren sind Hydrochinon, p-Methoxyphenol, 2,6-Di-tert-butyl-p-kresol, β-Naphtol, Phenothiazin und Nitrobenzol.

Farbstoffe, Pigmente und/oder photochrome Stoffe können der strahlungsempfindlichen Zusammensetzung in einer Menge bis zu 2 Gew.% zugesetzt werden. Sie dienen der Steuerung der Belichtungseigenschaften, der Identifizierung, der direkten Kontrolle des Belichtungsergebnisses oder ästhetischen Zwecken. Voraussetzung für die Auswahl und die Mengen solcher Zusätze ist es, daß sie - ebenso wie die Inhibitoren der thermischen Polymerisation - die Polymerisation der Zusammensetzung nicht wesentlich stören. Geeignet sind beispielsweise die löslichen Phenazinium-, Phenoxazinium-, Acridinium- und Phenothiaziniumfarbstoffe.

Das strahlungsempfindliche Aufzeichnungsmaterial enthält wenigstens eine, die strahlungsempfindliche Zusammensetzung enthaltende Schicht zwischen einem Schichtträger und einer Deckfolie.

Der Schichtträger sowie die Deckfolie kann beispielsweise aus einer handelsüblichen Kunststofffolie bestehen. Diese Kunststofffolien können beispielsweise aus Polyester wie Polyethylenterephthalat bestehen. Solche Kunststofffolien können eingefärbt oder farblos sein und für das aktinische Licht durchlässig oder auch undurchlässig sein. Der Schichtträger kann auch aus einem Metallblech wie beispielsweise einer dünnen Aluminiumplatte bestehen.

Das strahlungsempfindliche Aufzeichnungsmaterial kann eine oder auch mehr als eine strahlungsempfindliche Schicht enthalten. Ein Beispiel für ein strahlungsempfindliches Aufzeichnungsmaterial mit zwei strahlungsempfindlichen Schichten ist in US 5,370,968 beschrieben.

In anderen Schichten des strahlungsempfindlichen Aufzeichnungsmaterials, die gegebenenfalls auch strahlungsempfindlich sein können, können weitere Bindemittel Verwendung finden.

Das Bindemittel kann auch in anderen Schichten des strahlungsempfindlichen Aufzeichnungsmaterials verwendet werden.

Das erfindungsgemäße strahlungsempfindliche Aufzeichnungsmaterial wird bevorzugt in Verbindung mit sogenannten "Zwei-Komponenten-Farben" verwendet.

Die Verarbeitung des erfindungsgemäßen strahlungsempfindlichen Aufzeichnungsmaterials zu Relief-Druckformen umfaßt üblicherweise die Verarbeitungsschritte

    a) gegebenenfalls vollflächige und/oder bildmäßige Rückseitenbelichtung mit aktinischem Licht einer Wellenlänge zwischen 230 und 450 nm, insbesonders zwischen 300 und 450 nm,

    b) bildmäßige Hauptbelichtung mit aktinischem Licht einer Wellenlänge zwischen 230 und 450 nm, insbesonders zwischen 300 und 450 nm,

    c) Auswaschen (Entwickeln) der unbelichteten Bereiche der bildmäßig belichteten strahlungsempfindlichen Schicht mittels geeigneter organischer Entwickler, wobei auch eine gegebenenfalls vorhandene Deckschicht weggewaschen wird,

    d) Trocknen,

    e) gegebenenfalls Schlußbelichtung und

    f) gegebenenfalls Nachbehandlung der in dieser Weise erhaltenen Druckform.

Geeignete Lichtquellen für aktinisches Licht sind beispielsweise handelsübliche UV-Fluoreszensröhren in handelsüblichen Belichtungsgeräten.

Beispiele geeigneter organischer Entwickler sind aliphatische oder aromatische Kohlenwasserstoffe wie n-Hexan, n-Heptan, Octan, Petrolether, Ligroin, Limonen oder andere Terpene, Toluol, Xylol, Ethylbenzol oder Isopropylbenzol oder Gemische dieser Lösungsmittel; Ketone wie Aceton oder Methylethylketon; Ether wie beispielsweise Di-n-buthylether; Ester wie Essigsäureethylester, Acetessigsäureethylester, halogenierte aliphatische Kohlenwasserstoffe wie Methylenchlorid, Chloroform, Trichlorethan, Tetrachlorethylen, Dichlordifluorethan oder Gemische, die eines oder mehrere dieser genannten Lösungsmittel enthalten. Weiterhin können diese Lösungsmittel oder Lösungsmittelgemische Zusätze wie Tenside und Alkohole wie Ethanol, n-Butanol, Isopropanol, n-Pentanol, Benzylalkohol oder Methanol enthalten.

Übliche Methoden der Nachbehandlung der Druckformen sind das vollflächige Belichten mit aktinischem Licht der Wellenlänge zwischen 180 und 450 nm, das Nachbelichten mit sichtbarem Licht oder das Behandeln mit halogenhaltigen Lösungen.

Die geeignete Dosis an aktinischer Strahlung für die Verfahrensschritte a) und b) kann der Fachmann mit bekannten, in der Literatur wie beispielsweise "Technik des Flexodrucks", COATING Verlag Thomas& Co., CH-9001 St. Gallen, 3.Auflage, 1991 und "Flexography, Prinziples and Practices", Foundation of Flexographic Technical Association, Inc., New York, Fourth Edition, 1995 beschriebenen Verfahren ermitteln. Üblicherweise wird diese Strahlendosis bei vorgegebenen Belichtungsgeräten über die jeweilige Belichtungszeit kontrolliert.

Üblicherweise werden Reliefdruckformen im Flexodruck verwendet, welche eine Relieftiefe von 0,1 bis 7 mm aufweisen.

Die Technik des Flexodruckes, in der Relief-Druckplatten Verwendung finden sowie die Verarbeitung von strahlungsempfindlichen Aufzeichnungsmaterialien, ist beispielsweise in "Technik des Flexodrucks", COATING Verlag Thomas& Co., CH-9001 St. Gallen, 3.Auflage, 1991 und "Flexography, Prinziples and Practices", Foundation of Flexographic Technical Association, Inc., New York, Fourth Edition, 1995, beschrieben.

Die strahlungsempfindliche Zusammensetzung erlaubt vorteilhafter Weise die Herstellung von strahlungsempfindlichen Aufzeichnungsmaterialien in beliebigen Stärken und für beliebige Relieftiefen.

Ein weiterer Vorteil der strahlungsempfindlichen Zusammensetzung ist eine geringe Auslaugbarkeit der damit hergestellten Druckform. mit UV-C. Diese Nachbehandlung wird üblicherweise zur Entfernung der Klebrigkeit der Oberfläche verwendet.

Beispiel 1:

In einem Brabender Mischer wurden 60 Gewichtsteile des erfindungsgemäßen polymeren Bindemittels nach Formel (I) (Kraton TKG 101; n=1, m=0, X=2, Z=2 und einem gewichtsgemitteltem Molekulargewicht von 94000, A = Polystyrol mit insgesammt 18% Gewichtsanteil; UD = Polyisopren mit insgesammt 34% Gewichtsanteil; HD = Polyethylen-Butylen mit insgesammt 48% Gewichtsanteil) bei einer Temperatur von 140° C plastifiziert. Anschließend wurden 16 Teile Polybuten-1 (MW = 950) sowie 6 Teile Polybutadien-1,2 (MW = 1000) zugesetzt und solange mit dem polymeren Bindemittel bei obengenannter Temperatur geknetet, bis eine homogene Schmelze entstand. Danach wurde die Mischung der übrigen Bestandteile der Rezeptur, bestehend aus 13,4 Teilen Isobornylacrylat, 0,6 Teilen 2,4,6-Tri-tert-butylphenol, 3 Teilen Benzil-a,a-dimethylketal, 1 Teil Pentaerythrityltriacrylat, 0,005 Teile Zaphon-Rot 335 zugegeben und 30 Minuten geknetet. Anschließend lies man die geknetete homogene Schmelze erkalten und erhielt so die strahlungsempfindliche Zusammensetzung EZ1. Die Anteile der einzelnen Komponenten an der Formulierung sind jeweils in Gewichtsanteil angegeben.

In einer heizbaren Plattenpresse wird die strahlungsempfindliche Zusammensetzung bei einer Temperatur von 140° C zwischen einer 0,125 mm dikken Polyesterfolie und einer, mit Polyamid beschichteten Polyesterfolie (Deckfolie) unter Verwendung von einem 2 mm dicken Abstandhalter in einer Zeit von 2 Minuten ohne Druckaufbau zusammengepresst. Danach wird für 4 Minuten ein Druck von 28 Kg/cm2 aufgebaut und anschließend die Probe in der Presse bei diesem Druck auf etwa 55° C abgekühlt. Anschließend kann das so hergestellte erfindungsgemäße strahlungsempfindliche Aufzeichnungsmaterial EA1 entnommen werden.

Ein strahlungsempfindliches Aufzeichnungsmaterial VA1 wird zum Vergleich analog wie EA1 hergestellt wobei ein handelsübliches Styrol-Butadien-Styrol Blockcopolymer (Kraton D 1107 von Shell Chemicals) als Bindemittel an Stelle des erfindungsgemäßen Bindemittels verwendet wurde.

Beispiel 2:

Die zu untersuchenden strahlungsempfindlichen Aufzeichnungsmaterialien EA1 und VA1 wurden nach Ermittlung der korrekten Rückseiten- sowie Hauptbelichtungszeit mit den ermittelten Belichtungszeiten jeweils vollflächig belichteten und danach verarbeitet. Ein etwa 3x3 cm großes Stück wurde jeweils herausgeschnitten, gewogen und anschließend für 6 Stunden in eine esterhaltige Druckfarbe (Farbserie PV 77 der Fa. Siegwerk Druckfarben GmbH & Co. KG; Siegburg) eingelegt. Anschließend wurde die Farbe von der Probe mit einem saugfähigem Tuch abgewischt und letzte Reste mit einem mit Ethylacetat getränktem Tuch entfernt. Anschließend wurde die Probe erneut gewogen und deren relative Gewichtszunahme berechnet. Die mit dem strahlungsempfindlichen Aufzeichnungsmaterial EA1 hergestellte Probe wies dabei eine relative Quellung von 11% auf während bei entsprechend hergestellten, gleichdicken Proben von herkömmlichen, im Handel befindlichen strahlungsempfindlichen Aufzeichnungsmaterialien gleicher Schichtdicke zur Herstellung von Druckformen eine relative Quellung zwischen 23 und 31% beobachtet wurde. Die entsprechende, analog aus dem strahlungsempfindlichen Aufzeichnungsmaterial VA1 hergestellte Probe wies eine relative Gewichtszunahme von 28% auf.

Beispiel 3:

Das erfindungsgemäße strahlungsempfindliche Aufzeichnungsmaterial EA1 mit einer Schichtdicke von 2,84 mm (strahlungsempfindliche Schicht plus Unterlage) wurde zu einer Relief-Druckplatte verarbeitet und in einer handelsüblichen Flexodruckmaschine zum Verdrucken von Ester enthaltender Flexodruckfarbe (Farbserie PV 77 der Fa. Siegwerk Druckfarben GmbH & Co. KG, Siegburg) verwendet. Es wurden 60000 Meter Polyesterfolie bedruckt ohne daß sich die Qualität des Druckbildes während des Druckens nachteilig verändert hat. Handelsübliche Druckformen sind wegen deren starker Quellung in den entsprechenden Druckfarben nicht verwendbar.

Beispiel 4:

Es wurde ein strahlungsempfindliches Aufzeichnungsmaterial EA2 wie in Beispiel 1 beschrieben hergestellt, wobei Isobornylacrylat der strahlungsempfindlichen Zusammensetzung nur noch zu 12,7 Teilen und zusätzlich 0,7 Tridecylacrylat (Tg des Homopolymeren = - 75° C) zugesetzt wurden. Es wurde dabei eine gewünschte Verbesserung der Flexibilität der damit hergestellten Druckform beobachtet ohne daß sich andere chemische oder physikalische Eigenschaften der Druckform nachteilhaft verändert haben.

**Patentansprüche**

**1.** Strahlungsempfindliches Aufzeichnungsmaterial, umfassend einen Schichtträger, eine Deckfolie und mindestens eine dazwischenliegenden photopolymerisierbare Schicht enthaltend a) mindestens ein polymeres thermoplastisches, elastomeres Bindemittel, b) mindestens eine additionspolymerisierbare endständig ethylenisch ungesättigte Verbindung, c) mindestens einen Photoinitiator und/oder Photoinitiatorsystem und d) gegebenenfalls einen oder mehrere Hilfsstoffe, und gegebenenfalls weitere, zwischen der Deckfolie und dem Schichtträger liegende Schichten, **dadurch gekennzeichnet, daß** mindestens eine photopolymerisierbare Schicht als polymeres thermoplastisches, elastomeres Bindemittel ein radiales Blockcopolymer der Formel (I)

$$(I) \qquad ((A)n\text{-}(HD))_X\text{-}Y\text{-}((UD)\text{-}(A)m)_Z$$

enthält, wobei A ein Polyvinylarylblock mit einem gewichtsgemitteltem Molekulargewicht von 4000 bis 20000 ist, m und n jeweils 0 oder 1 ist und im Molekül mindestens zwei Polyvinylarylblöcke A vorliegen müssen, HD ein hydrierter Polymerblock eines konjungierten Dienes mit einem gewichtsgemitteltem Molekulargewicht von 10000 bis 100000, Y eine mehrfunktionale Verbindung, UD ein nicht hydrierter Polymerblock eines konjungierten Dienes mit einem gewichtsgemitteltem Molekulargewicht von 1000 bis 80000,
x eine ganze Zahl von 2 und 20, z eine ganze Zahl von 1 und 10 ist, die Summe von x und z einen Wert von 3 bis 30 beträgt und der gewichtsmäßige Anteil der Summe der Polyvinylarylblöcke 4 bis 35% beträgt.

2. Strahlungsempfindliches Aufzeichnungsmaterial nach Anspruch 1, **dadurch gekennzeichnet daß** in der Formel (I) x gleich 2, 3 oder 4, z gleich 1, 2, 3 oder 4 und die Summe von x und z gleich 3, 4, 5 oder 6 ist.

3. Strahlungsempfindliches Aufzeichnungsmaterial nach Anspruch 1 oder 2, **dadurch gekennzeichnet daß** das polymere thermoplastische, elastomere Bindemittel ein radiales Blockcopolymer der Formel (II)

$$(II) \qquad (A\text{-}(HD))_X\text{-}Y\text{-}(UD)_Z$$

ist, wobei A ein Polyvinylarylblock mit einem gewichtsgemitteltem Molekulargewicht von 4000 bis 20000 ist, im Molekül mindestens zwei Polyvinylarylblöcke A vorliegen müssen, HD ein hydrierter Polymerblock eines konjungierten Dienes mit einem gewichtsgemitteltem Molekulargewicht von 10000 bis 100000, Y eine mehrfunktionale Verbindung, UD ein nicht hydrierter Polymerblock eines konjungierten Dienes mit einem gewichtsgemitteltem Molekulargewicht von 1000 bis 80000, x eine ganze Zahl von 2 und 20, z eine ganze Zahl von 1 und 10 ist, die Summe von x und z einen Wert von 3 bis 30 beträgt und der gewichtsmäßige Anteil der Summe der Polyvinylarylblöcke 4 bis 35% beträgt.

4. Strahlungsempfindliches Aufzeichnungsmaterial nach Anspruch 3, **dadurch gekennzeichnet daß** in der Formel (II) x gleich 2, 3 oder 4, z gleich 1, 2, 3 oder 4 und die Summe von x und z gleich 3, 4, 5 oder 6 ist.

5. Strahlungsempfindliches Aufzeichnungsmaterial nach Anspruch 1 bis 4, **dadurch gekennzeichnet daß** in der Formel (I) x und z jeweils 2 ist.

6. Strahlungsempfindliches Aufzeichnungsmaterial nach Anspruch 1 bis 5, **dadurch gekennzeichnet, daß** die Vinylarylblöcke A in Formel (I) im wesentlichen aus Polystyrol bestehen.

7. Strahlungsempfindliches Aufzeichnungsmaterial nach Anspruch 1 bis 6, **dadurch gekennzeichnet, daß** HD im wesentlichen aus hydriertem Polybutadien besteht.

8. Strahlungsempfindliches Aufzeichnungsmaterial nach Anspruch 1 bis 7, **dadurch gekennzeichnet, daß** UD im wesentlichen aus Polyisopren besteht.

9. Strahlungsempfindliches Aufzeichnungsmaterial nach Anspruch 1 bis 8, **dadurch gekennzeichnet, daß** sie als additionspolymerisierbare endständig ethylenisch ungesättigte Verbindung Isobornylacrylat enthält.

10. Strahlungsempfindliches Aufzeichnungsmaterial nach Anspruch 1 bis 9, **dadurch gekennzeichnet, daß** sie als additionspolymerisierbare endständig ethylenisch ungesättigte Verbindungen Isobornylacrylat und ein oligofunktionales Acrylat oder Methacrylat enthält.

11. Strahlungsempfindliches Aufzeichnungsmaterial nach Anspruch 1 bis 10, **dadurch gekennzeichnet, daß** sie als additionspolymerisierbare endständig ethylenisch ungesättigte Verbindungen im wesentlichen eine Kombination von Isobornylacrylat, einem oligofunktionalem Acrylat oder Methacrylat und einem monofunktionalem Acrylat oder Methacrylat, dessen Homopolymerisat einen Glasübergangspunkt unter -40° C aufweist, enthält.

12. Verwendung des strahlungsempfindlichen Aufzeichnungsmaterials nach einem der Ansprüche 1 bis 12 zur Herstellung von Druckformen für den Flexodruck.

**Claims**

1. Irradiation-sensitive recording material comprising a carrier, a cover foil and at least one interposed, photopolymerizable layer, comprising a) at least one polymeric thermoplastic, elastomeric binder, b) at least one compound with terminal ethylenic unsaturation and capability for addition polymerization, c) at least one photoinitiator and/or photoinitiator system, and d) optionally one or several auxiliary agents,
and optionally additional layers between the cover foil and the carrier,
**characterized in that**,
at least one of the photopolymerizable layers comprises as polymeric thermoplastic, elastomeric binder a radial block copolymer of the formula (I)

$$(I) \qquad ((A)n\text{-}(HD))_x\text{-}Y\text{-}((UD)\text{-}(A)m)_z$$

wherein A is a polyvinylaryl block with a weight-averaged molecular weight of 4000 to 20000, m and n each are 0 or 1, and at least two polyvinylaryl blocks A must be present in the molecule, HD is a hydrogenated polymer block of a conjugated diene with a weight-averaged molecular weight of 10000 to 100000, Y is a multi-functional compound, UD is a non-hydrogenated polymer block of a conjugated diene with a weight-averaged molecular weight of 1000 to 80000, x is an integer from 2 to 20, z is an integer from 1 to 10, the sum of x and z having a value from 3 to 30, and the weight proportion of the sum of polyvinylaryl blocks being 4 to 35 %.

2. Irradiation-sensitive recording material according to claim 1,
**characterized in that**,
in formula (I) x equals 2, 3, or 4, z equals 1, 2, 3, or 4, and the sum of x and z equals 3, 4, 5, or 6.

3. Irradiation-sensitive recording material according to claim 1 to 2
**characterized in that**,
the polymeric thermoplastic, elastomeric binder is a radial block copolymer of the formula (II)

$$(II) \qquad (A\text{-}(HD))_x\text{-}Y\text{-}(UD)_z$$

wherein A is a polyvinylaryl block with a weight-averaged molecular weight of 4000 to 20000, at least two polyvinylaryl block A must be present in the molecule, HD is a hydrogenated polymer block of a conjugated diene with a weight-averaged molecular weight of 10000 to 100000, Y is a multi-functional compound, UD is a non-hydrogenated polymer block of a conjugated diene with a weight-averaged molecular weight of 1000 to 80000, x is an integer from 2 to 20, z is an integer from 1 to 10, the sum of x and z having a value from 3 to 30, and the weight proportion of the sum of polyvinylaryl blocks being 4 to 35 %.

4. Irradiation-sensitive recording material according to claim 3
**characterized in that**,
in formula (II) x equals 2, 3, or 4, z equals 1, 2, 3, or 4, and the sum of x and z equals 3, 4, 5, or 6.

5. Irradiation-sensitive recording material to claim 1 to 4
**characterized in that**,
x and z in formula (I) each equal 2.

6. Irradiation-sensitive recording material according to claim 1 to 5
**characterized in that**,
the polyvinylaryl blocks A in formula (I) consist essentially of polystyrene.

7. Irradiation-sensitive recording material according to claim 1 to 6
**characterized in that**,
HD consists essentially of hydrogenated polybutadiene.

8. Irradiation-sensitive recording material according to claim 1 to 7
**characterized in that**,
UD consists essentially of polyisoprene.

9. Irradiation-sensitive recording material according to claim 1 - 8,
**characterized in that**,
it contains isobornyl acrylate as compound with terminal ethylenic unsaturation and capability for addition polymerization.

10. Irradiation-sensitive recording material according to claim 1 - 9,
**characterized in that**,
it contains isobornyl acrylate and an oligo-functional acrylate or methacrylate as compounds with terminal ethylenic unsaturation and capability for addition polymerization.

11. Irradiation-sensitive recording material according to claim 1 - 10,
**characterized in that**,
it contains as compounds with terminal ethylenic unsaturation and capability for addition polymerization essentially a combination of isobornyl acrylate, an oligo-functional acrylate or methacrylate, and a mono-functional acrylate or methacrylate, the homopolymer of which has a glass transition temperature below -40 °C.

**12.** Use of the irradiation-sensitive recording material according to claim 1 - 11 for preparation of printing forms for flexographic printing.

## Revendications

**1.** Matériau d'enregistrement sensible au rayonnement comprenant un support, une feuille de couverture et au moins une couche photopolymérisable intermédiaire, comprenant a) au moins un liant polymère thermoplastique élastomère, b) au moins un composé à insaturation terminale en éthylène et se prêtant à une polymérisation par addition, c) au moins un photo-amorceur et/ou un système photoamorceur, et d) un ou plusieurs agents auxiliaires optionnels et des couches additionnelles optionnels entre la feuille de couverture et le support, **caractérisé en ce que** au moins une des couche photopolymérisable comprend un copolymère bloc radial ayant formule (I) comme liant polymère thermoplastique élastomère

$$(I) \qquad ((A)n\text{-}(HD))_x\text{-}Y\text{-}((UD)\text{-}(A)m)_z$$

où A est un bloc de polyvinylaryle d'un poids moléculaire moyen entre 4000 et 20000, m et n correspondant chacun à 0 ou 1, et au moins deux bloc de polyvinylaryle A devant être présents dans le molécule, HD étant un bloc polymère hydrogéné d'un diène conjugué ayant un poids moléculaire moyen compris entre 10000 et 100000, Y étant un composé multifonctionnel, UD étant un bloc polymère non hydrogéné d'un diène conjugué d'un poids moléculaire moyen compris entre 1000 à 80000, x étant un nombre entier compris entre 2 et 20, z étant un nombre entier compris entre 1 et 10, la somme de x et z ayant une valeur compris entre 3 et 30 et le rapport en poids de la somme des blocs de polyvinylaryle étant de 4 à 35 %.

**2.** Matériau d'enregistrement sensible au rayonnement selon la revendication 1 **caractérisée en ce que**
dans la formule (I) x correspond à 2, 3 ou 4, z correspondant à 1, 2, 3 ou 4 et la somme de x et z correspondant à 3, 4, 5 ou 6.

**3.** Matériau d'enregistrement sensible au rayonnement selon les revendications 1 ou 2 **caractérisée en ce que**
le liant polymère thermoplastique élastomère est un copolymère bloc radial selon la formule (II)

$$(II) \qquad (A\text{-}(HD))_x\text{-}Y\text{-}(UD)_z$$

où A est un bloc de polyvinylaryle d'un poids moléculaire moyen compris entre 4000 et 20000, au moins deux blocs de polyvinylaryle A devant être présents dans la molécule, HD étant un bloc polymère hydrogéné d'un diène conjugué ayant un poids moléculaire moyen compris entre 10000 et 100000, Y étant un composé multifonctionnel, UD étant un bloc polymère non hydrogéné d'un diène conjugué d'un poids moléculaire moyen compris entre 1000 et 80000, x étant un nombre entier compris entre 2 et 20, z étant un nombre entier compris entre 1 et 10, la somme de x et z ayant une valeur compris entre 3 et 30 et le rapport en poids de la somme des blocs de polyvinylaryle étant de 4 à 35 %.

**4.** Matériau d'enregistrement sensible au rayonnement selon la revendication 3 **caractérisée en ce que**
dans la formule (II) x correspond à 2, 3 ou 4, z correspondant à 1, 2, 3 ou 4 et la somme de x et z correspondant à 3, 4, 5 ou 6.

**5.** Matériau d'enregistrement sensible au rayonnement selon les revendications 1 à 4, **caractérisé en ce que**
x et z dans la formule (I) correspondent chacun à 2.

**6.** Matériau d'enregistrement sensible au rayonnement selon les revendications 1 à 5, **caractérisé en ce que**
les blocs de polyvinylaryle A dans la formule (I) sont constitués pour l'essentiel de polystyrène.

**7.** Matériau d'enregistrement sensible au rayonnement selon les revendications 1 à 6, **caractérisé en ce que**
HD est constitué pour l'essentiel de polybutadiène hydrogéné.

**8.** Matériau d'enregistrement sensible au rayonnement selon les revendications 1 à 7, **caractérisé en ce que**
UD est constitué pour l'essentiel de polyisoprène.

**9.** Matériau d'enregistrement sensible au rayonnement selon les revendications 1 à 8, **caractérisé en ce qu'**
il contient de l'acrylate d'isobornylique comme composé à insaturation terminale en éthylène et se prêtant à une polymérisation par addition.

**10.** Matériau d'enregistrement sensible au rayonnement selon les revendications 1 à 9, **caractérisé en ce qu'**

il contient de l'acrylate d'isobornylique et un acrylate ou un méthacrylate oligofonctionnel comme composés à insaturation terminale en éthylène et se prêtant à une polymérisation par addition.

11. Matériau d'enregistrement sensible au rayonnement selon les revendications 1 à 10, **caractérisé en ce qu'**
    il contient comme composés à insaturation terminale en éthylène et se prêtant à une polymérisation par addition pour l'essentiel une combinaison d'acrylate isobornylique et un acrylate ou un méthacrylate oligofonctionnel, et un acrylate ou un méthacrylate monofonctionnel, l'homopolymère correspondant ayant une température de transition vitreuse inférieure à -40 °C.

12. Utilisation d'un matériau d'enregistrement sensible au rayonnement selon les revendications 1 à 11 pour la préparation de formes d'impression pour impression flexographique.